# EUROPEAN PATENT SPECIFICATION

(11) **EP 3 610 610 B1**
(45) Date of publication and mention of the grant of the patent: **27.09.2023**
(21) Application number: 18723059.4
(22) Date of filing: 11.04.2018
(51) Int. Cl.: H02J 13/00, H04L 12/28, G01R 19/25

(54) **MODULAR MULTIFUNCTIONAL HOME AUTOMATION DEVICE ADAPTED TO BE INSERTED AS AN ELEMENT IN AN ELECTRICAL BOX**
MODULARE MULTIFUNKTIONALE HEIMAUTOMATISIERUNGSVORRICHTUNG, DIE ALS ELEMENT IN EINEN SCHALTSCHRANK EINGESETZT WERDEN KANN
DISPOSITIF DOMOTIQUE MULTIFONCTIONNEL MODULAIRE CONÇU POUR ÊTRE INSÉRÉ EN TANT QU'ÉLÉMENT DANS UN COFFRET ÉLECTRIQUE

(30) Priority: 13.04.2017 IT 201700041431
(43) Date of publication of application: 19.02.2020
(73) Proprietor: Zerouno S.r.l., 20089 Rozzano (MI) (IT)
(72) Inventor: RIZZO, Paolo, I-20090 Assago (MI) (IT)
(74) Representative: Borsano, Corrado
(86) International application number: PCT/IB2018/052529
(87) International publication number: WO 2018/189690

(56) References cited:
- WO-A1-2017/021717
- US-A1- 2001 025 349
- US-A1- 2006 161 270
- US-A1- 2014 074 307
- US-A1- 2014 195 064
- US-A1- 2014 248 802

## Description

### Field of application

The present invention relates to the field of home automation and precisely to a multifunctional home automation device, possibly also modular, adapted to be inserted as an element in an electrical box.

### Prior Art

Introducing a home automation solution in a home or an office, with the solutions currently available, often has a significant impact on the existing electrical system and may require new wiring, the replacement of all the electrical components or the installation of additional devices, and the intervention of highly specialist personnel, with a significant impact on the implementation times and costs of the home automation solution.

Home automation devices known in the prior art have a more limited functional role and do not satisfy at least the following requirements:
- using existing wiring and being installable also by unqualified personnel, it not being necessary to modify the system or the related certifications;
- being installable in the maximum size of an "electrical element";
- being dimensionally compatible with existing electrical boxes, in the different national or international standards;
- being compatible with existing frames and plates, with the dimensional granularity of an individual "electrical element";
- allowing the replacement of some elements, automating only one part and guaranteeing the continuity of the other existing functions;
- extending and automating existing functions, such as checking an electrical socket, without replacing the corresponding element;
- separating the active part (logical and functional) from the electromechanical one, allowing the installation and replacement of the active part, without dismounting the plate and the frame;
- using network standard protocols (TCP/IP) and allowing the domestic communication network and existing internet connections to be exploited safely through the installed router;
- being coordinated by software, connected to cloud services, able to extend the functionality of the installed modules and to provide, by way of non-limiting example, energy saving, diagnostic and information services to be provided, or other services with social value, such as the remote supervision of elderly people or newborn babies, or sending out civil protection alarms.

Patent application US2014/248802-A1 shows an example of the aforementioned known home automation devices with limited functions. It describes an electrical socket in which it is possible to insert a unit of measurement of the voltage waveform, a unit of measurement of the current waveform, a communication unit, a control unit and an arithmetic unit. The measurement of voltage and current is performed on the waveforms of voltage and current supplied to household appliances through corresponding power plugs connected to the household appliances themselves. The communication unit is a unit that transmits the voltage waveform and the current waveform or a processing result of the waveforms to a server. The control unit controls the switching of the power supplied to the household appliance and the quantity of energy supplied based on a control signal. Therefore, the device described does not satisfy all of the aforementioned functional requirements.

### Summary of the invention

The present invention is defined in the appended independent claim 1 to which reference should be made. Advantageous features are set out in the appended dependent claims.

An object of the present invention is therefore that of proposing a multifunctional home automation device adapted to be inserted as an element in an electrical box, that aims to overcome all the aforementioned drawbacks.

The subject matter of the present invention is a home automation device with a multifunctional structure adapted to be inserted as an element in an electrical box, containing the following electrical and electronic components:
- a transformer/power supply for generating a low voltage to supply the other components,
- a voltage modulator with electronic regulators of the electric power generated,
- an electronic processor for the management and control of the functions of the home automation device,
- a Wireless and/or Wired communication system for bidirectional communication with the outside,
- a non-volatile memory to save information that allows the proper functioning of the home automation device, even in case of power failure,
the enclosure of the device having the size of a single "electric element" and being constructed to have outer shapes compatible with frames and plates of the existing electrical boxes based on the different national or international standards.

The multifunctional structure of the electrical and electronic components is therefore divided into:
- means for supplying low voltage to said electrical and electronic components;
- means for actuating controls coming from local and/or remote specialized functional components;
- means for communicating and managing I/O data flows, with said local and/or remote specialized functional components;
- functional specialization means, for allowing: a) local and/or remote control, through a human interaction interface (LCD + Touch Screen); b) the detection of information and data on the environment, through sensors and/or camcorders; c) communication with other sub-systems, through gateway.

In accordance with a first embodiment, the enclosure of the device has the size of a single "electric element" and is constructed to have different outer shapes and to be compatible with frames and plates of the existing electrical boxes based on the different national or international standards.

The device can be realized so that its components are inserted in enclosures of different shapes, according to the functional specialization of the device, so as to guarantee mutual shape compatibility.

In accordance with a second embodiment, the device comprises in said modular structure two physical modules:
- a hollow frame module, with a shape adapted to be grafted permanently but removably as an element in an electrical box, said frame module having a front opening, provided with electrical contacts on the outer bottom for wiring to the power grid or net, also provided with electrical contacts on the inner bottom;
- an element module adapted to be removably inserted in said hollow frame module through said front opening, and adapted to contain said electrical and electronic components, said element module having a closed box structure and being provided with electrical contacts adapted for insertion into the electrical contacts of the frame module.

The modular structure represents a more complex embodiment, with respect to the one based on a single enclosure. The present description of the invention will set out in more detail the characteristics of this more complex embodiment, solely by way of illustrative and thus non-limiting example.

With respect to home automation devices known in the prior art, the device proposed in the present invention offers the following improvements (also with respect to the device described in the aforementioned patent application US2014/248802-A1), thanks to its modular structure:
- it is possible to functionally specialize the product, through a corresponding hardware extension;
- it is possible to replace only the module that may be faulty, among those that constitute the active part of the device;
- it is possible to delegate the envisaged function for one device to another, simply through a logical configuration that does not therefore require the replacement or physical inversion of the elements;
- it is possible to configure the function of the device and the corresponding management interface in accordance with the functional role of the product;
- when the functional module contains a management interface it is possible to aesthetically personalize such interface.

The home automation device of the invention does not perform the electrical socket function and therefore does not correspond functionally to patent application US2014/248802-A1. On the contrary, the invention proposed is a modular multifunctional home automation device, with extended functions, able to communicate with a specific configuration and control application that may be installed in: a mobile device (smart-device), a computer and a cloud infrastructure.

The home automation device of the invention is not a smart-plug, but rather a smart-actuator provided with functional interfaces that can be grouped, for example, into the following functional classes: Control, Detection, Communication.

It is particular subject matter of the present invention a home automation device with a multifunctional structure adapted to be inserted as an element in an electrical box, as will be better described in the claims, which form an integral part of the present description.

### Brief description of the figures

Further objects and advantages of the present invention will become clear from the following detailed description of an embodiment thereof (and of its variants), and with reference to the appended drawings provided solely by way of non-limiting example, wherein:
figures 1 to 6 show block diagrams of the electrical/electronic functions of the device according to the invention;
figures 7 to 13 show an embodiment of the invention with a modular structure;
figure 14 shows an embodiment of the device according to the invention with a single element.

The same reference numbers and letters in the figures identify the same elements or components.

### Detailed description

Non-limiting embodiments of the home automation device according to the invention are described below.

The device is an "electric element", having the size of a single element, compatible with own frames, for mounting on electrical boxes, e.g. according to Italian standard 502 or higher. However, the device may have an enclosure with a different outer shape in order to guarantee compatibility with different frames present on the market.

The device contains the following essential electrical and electronic components, described in detail below: Transformer/Power supply 11, Voltage modulator 12, Communication system (Wireless and/or Wired) 13, Electronic processor 14, Non-volatile memory 15. The device may contain the following additional electrical and electronic components, described in detail below: Voltage sensor 21, Current meter 31, Tank capacitor 41.

The device is equipped with at least four contacts: two input (Phase = F [+] and Neutral = N [-]) and two output (U1 and U2) for wiring in the existing electrical grid or net, e.g. AC (85-260Volt) or DC (12-48Volt).

The contacts may be screw or spring terminals, in which the electrical cables can be wired, and are sized to support a 10/16A current.

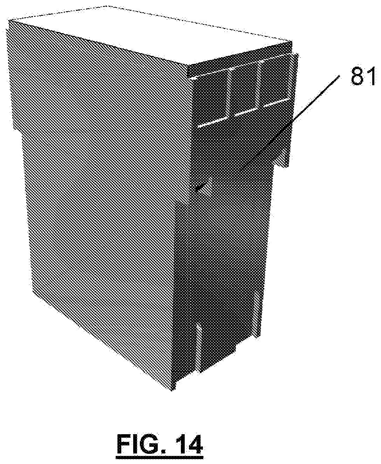

A physical example of the device, with an enclosure having the shape of a single element compatible with a frame present on the market, is shown in figure 14, by the number 81.

The functional components necessary to guarantee the product specialization will be inserted into such enclosure.

According to a possible variant, the device can preferably be divided into two main physical elements, to guarantee greater adaptability and flexibility of use, referred to below as "Frame" for the frame and "Element" for the element.

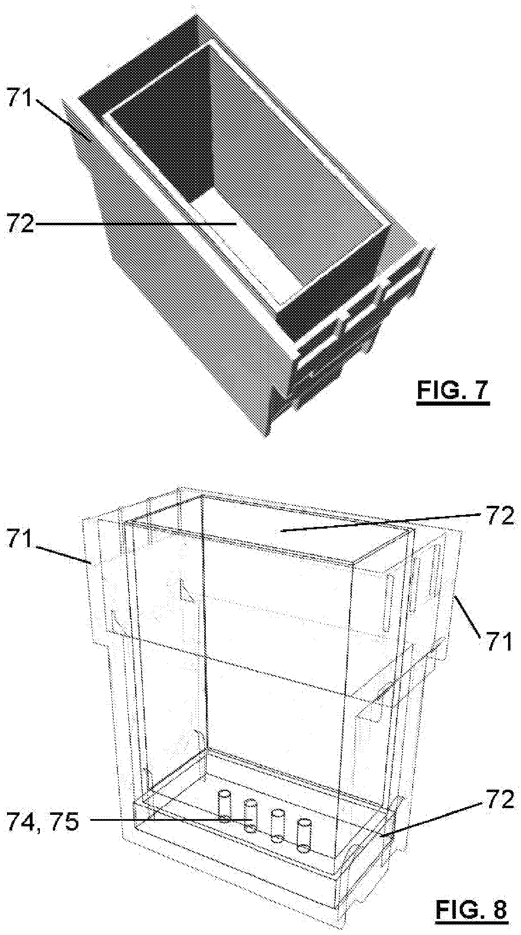

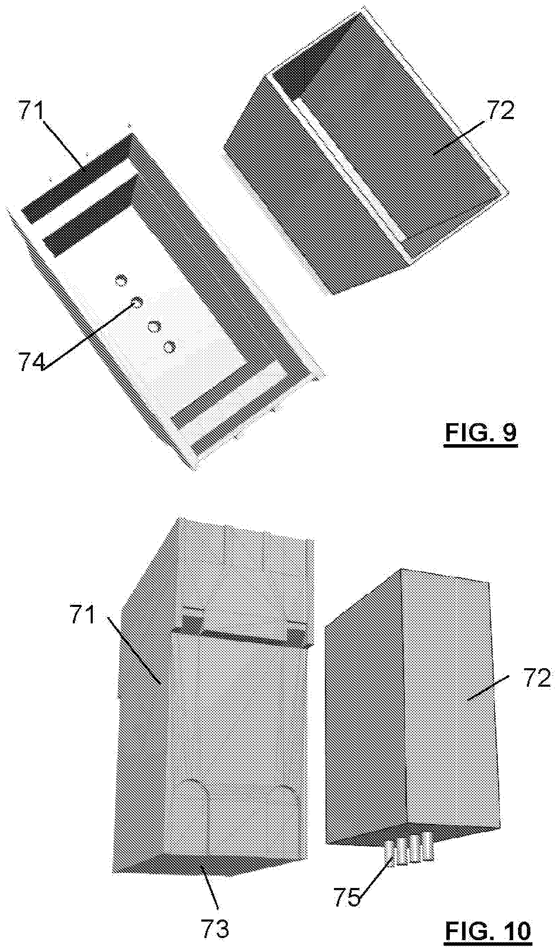

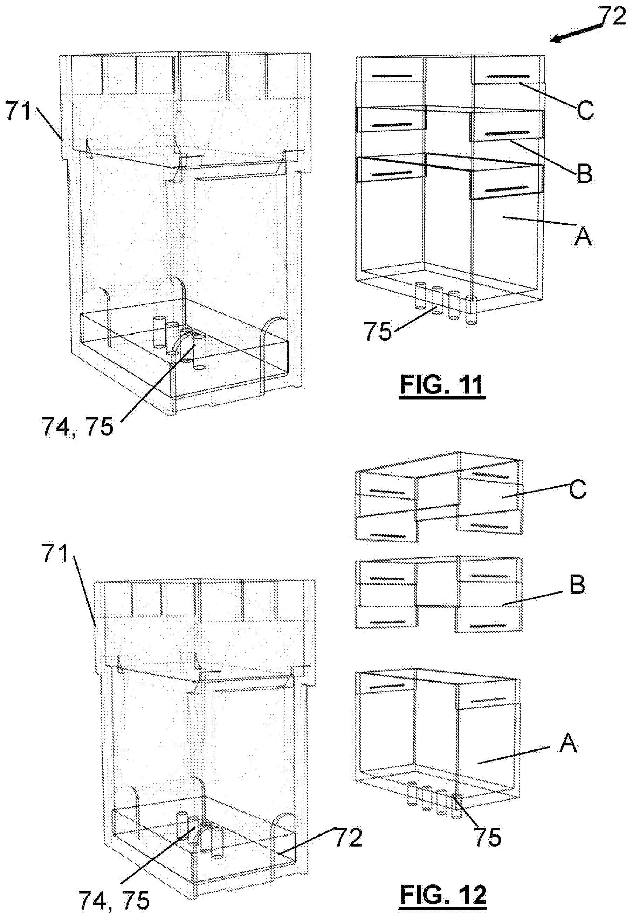

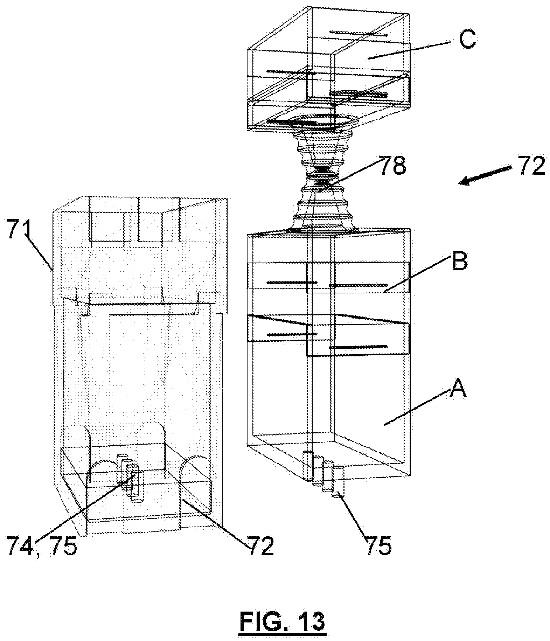

Physical examples of said elements are shown in figures 7-13.

The Frame 71 is an entirely hollow frame with example sizes described below. It is equipped with delimiting walls, with a front opening and having the opposite wall to the front opening as the bottom.

The Frame 71 is the mechanical element functional to the wiring and shape compatibility with frames for the electrical boxes in which it is to be inserted, inserted permanently and removably. It houses on the outer bottom the contacts 73 of the wiring for the existing power grid or net.

The outer shape of the Frame 71 is compatible with own frames, for mounting on electrical boxes. However, the Frame may have a different outer shape in order to guarantee compatibility with different frames present on the market.

On the inner bottom of the Frame 71 there are female (or male) contacts 74 for the insertion of the male (or female) contacts 75 of the Element 72. The inner contacts of the Frame are constructed so as to guarantee protection against accidental electric shocks.

The Element 72 is the active element, which can be inserted removably into the Frame 71, for example through a "slide" system provided inside the latter. A simple front insertion operation allows the Element 72 to be installed. Any subsequent Element replacement operation can be performed conveniently without having to dismount the outer plate and electrical frame. The Element has a closed box structure.

According to a possible variant, the Element 72 is preferably divided in turn into three physical elements:
A) Actuator Module, B) Logical Module, C) Functional Module.

These three modules are coupled to each other through relevant "clips", as though they were separate but integral layers, such as to constitute a single composite element.

The three Modules are suitably interconnected in series with each other through relevant contacts, preferably in the indicated order, and contain the following elements described in detail below.

The Actuator Module A) may contain: Transformer/Power supply, Voltage modulator, described below.

The Logical Module B) may contain: Electronic processor, Non-volatile memory, described below.

The Functional Module C) may comprise one or more components, as described below. The following further elements: Wireless and/or Wired communication system, Voltage sensor, Current meter, Tank capacitor may be contained jointly or separately in the modules A, B or C.

The actuator module (A), logical module (B), functional module (C) are preferably connected in cascade, in respectively internal, intermediate and external positions in the element module (72), so that an outer part of the functional module (C) can partially project from the outer edge of the electrical box, to an extent corresponding to the functionality. The modular organization of the Element facilitates the installation, diagnostics and maintenance, interchangeability of components and system evolution with the containment of costs.

In particular, each of the three modules A, B, C has a closed box structure, intercommunicating with the other modules, and can be replaced independently from the others, if necessary, for example following any malfunctioning or breakages, or for the modification, integration and addition of functions not previously envisaged.

In any case, regardless of the physical location of the various electrical/electronic elements between said actuator module (A), logical module (B), functional module (C), the multifunctional structure of the electrical and electronic components described is divided into:
- means for supplying low voltage to the electrical and electronic components;
- means for actuating controls coming from the local and/or remote specialized functional components;
- means for communicating and managing I/O data flows, with the local and/or remote specialized functional components;
- functional specialization means, for allowing: a) local and/or remote control, through a human interaction interface (LCD + Touch Screen); b) the detection of information and data on the environment, through sensors and/or camcorders; c) communication with other sub-systems, through gateway.

Between the Logical Module B) and the Functional Module C) a joint 78 may be inserted, with a swivelling articulation, able to cover a hemisphere. The joint is equipped with relevant contacts for connecting the Functional Module to the Logical Module. The joint may extend beyond the dimension (depth) of the Element outside the electrical box.

In one embodiment the size of the enclosure of the device is less than or equal to the following measurements: Width 23 mm, Height 50mm, Depth 52mm.

The maximum depth, defined herein, relates to the part of the device inside the electrical box that houses it. The outer part can extend to guarantee the functions described below.

In the case of the modular embodiment, such measurement relates to the Frame 71 which is substantially a parallelepiped.

The Element 72 will also preferably be parallelepiped-shaped, with dimensions suitable for being inserted in the Frame.

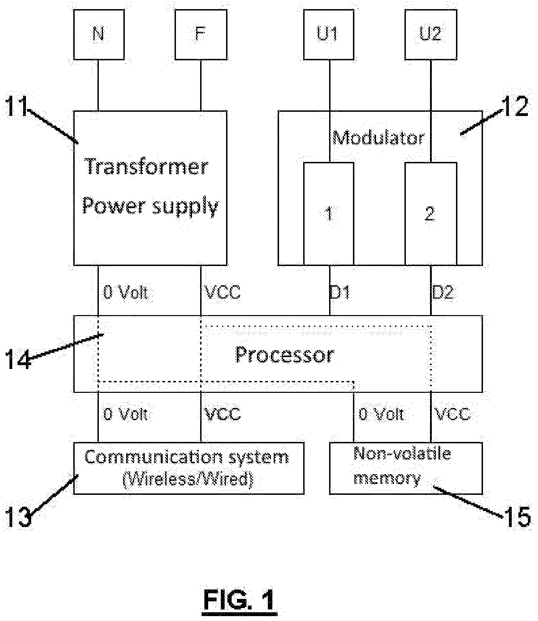

With reference to figures 1 to 6, the functional blocks of the home automation device are described, with preferable reference to the components contained in the Actuator Module A) and in the Logical Module B).

The Transformer/Power supply 11 generates a low voltage Vcc which allows the Process 14, Communication System (Wireless and/or Wired) 13 and Non-volatile Memory 15 modules to operate. By way of example, there could be an AC/DC regulated power supply, e.g. the component that can be found on the market with the initials RECOM^{®} RAC02-SE/277/W. The tank capacitor 41 has the purpose of supplying the other components (in the event of sudden absence of power from the grid) and not external devices, since the device is not a smart plug.

The Voltage modulator 12 can be comprised of one or two electronic regulators that modulate the electric power output independently.

By way of example, two classic "dimmer" circuits can be designed to regulate the brightness of a lamp, realized with a power *triac* which has a *diac* driver, which is driven, through a filter and control circuit, by the digital outputs of the Processor module. They supply the voltages on the outputs U1 and/or U2.

The Processor 14 is the smart part of the device. It is powered by the low voltage output of the Transformer/Power supply module 11, has the possibility to communicate between the Communication system (Wireless and/or Wired) 13, has the task of driving the digital outputs D1, D2 which are connected to the Voltage modulators 12 and finally has the possibility to access a Non-volatile memory 15 for reading or writing data.

By way of example, the Processor module can be realized with a SoC (System On Chip).

The Communication system (Wireless and/or Wired) 13 is the part of the device that allows the local application (described below) to communicate externally with other application components installed on smart devices and on clouds, as well as with other home automation devices according to the invention. Like the Processor, the Communication system 13 is powered by the low voltage output Vcc of the Transformer/Power supply module and has the task of providing to the Processor the communication function with the Application and the other devices. The connection between the Communication system (Wireless and/or Wired) and the Processor can be realized using any "on board" communication standard such as SDI "Serial Digital Interface".

The Non-volatile memory 15 is the part of the device in which the information is contained that allows the correct operation of the system, even in the event of a restart after a power cut, because it contains the configuration and status data.

It is powered by the low voltage output Vcc of the Transformer/Power supply module. The connection between the Non-volatile memory and the Processor can be realized using any "on board" communication standard such as SDI "Serial Digital Interface".

By way of example, it is possible to envisage a SoC that comprises a Processor, Communication system (Wireless and/or Wired) and Non-volatile memory, so as to facilitate the electronic design step.

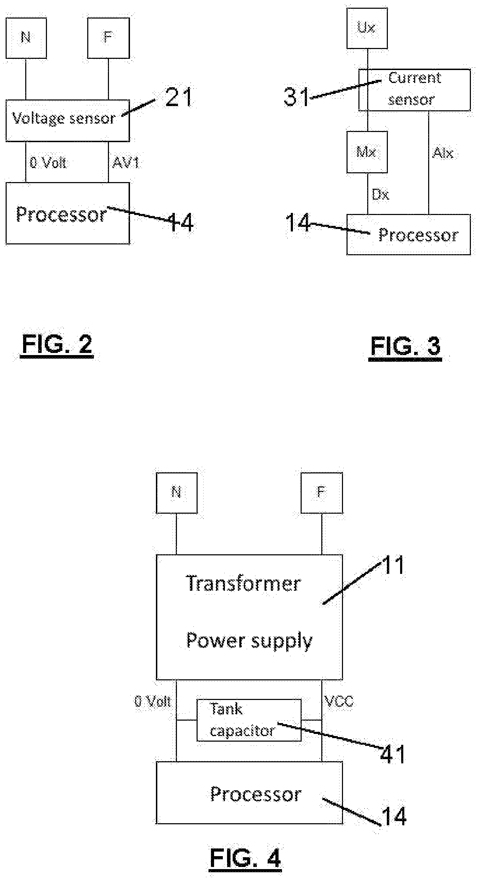

With reference to Figure 2, the voltage sensor 21, which can be inserted at the Transformer/Power supply 11 level, can be realized using a capacitance splitter, with an analog signal (AV1) at the output, which can be measured through an ADC of the SoC described in the Processor module. The function of the voltage sensor is that of providing status and diagnostics information.

With reference to Figure 3, the current sensor 31, present on each output Ux, driven by a digital output Dx of the Processor through the Modulator Mx, can be realized with a Hall effect sensor, with an analog signal (AIx) at the output, which can be measured through an ADC of the SoC described in the Processor module. An example of an integrated circuit with a Hall effect sensor is the model ACS730 made by Allegro^{®}. The function of the current sensor is that of providing qualitative control and diagnostic information.

With reference to figure 4, the tank capacitor 41 can be inserted at the output of the Transformer/Power supply module. This capacitor has the aim of guaranteeing the operation of the device, for a determined period, also in the event of power grid or net failure. In the event of absence of voltage from the grid or net, the tank capacitor powers the system in order to allow it to save all the configuration and status information as well as immediately reporting the lack of voltage to the central system (local application and/or cloud). Preferably with reference to the Logical module B), it may contain software that manages the communication between one or more intercommunicating home automation devices according to the invention, and the Application installed on other external devices such as smart watches, smartphones, tablets or computers, through standard (Wireless and/or Wired) communication systems, TCP/IP network protocols and routers.

In particular, the software installed in the Logical module B) allows the device to communicate with the Application, that can be installed on the external devices mentioned above, allowing the latter to manage the device itself, from configuration to operation, also remotely. The Application controls and coordinates the assembly of the devices and interacts with the Cloud services.

The Logical module B) contains the intelligence of the device and the Non-volatile memory 15 allows all the Element-related parameters to be saved and stored in the event of a power cut. The Logical module also guarantees that the essential functions of the device itself can continue to operate locally, without depending on a remote management of the Application. During the first configuration step ("plug-in" of the Element into the Frame) or reset step, the Logical module B), in an embodiment where the communication system is Wi-Fi, goes into "Hot spot" status, introducing itself to the management application with its own Mac Address.

Through the relevant configuration procedure, the user can assign an identification name to the device (typically the name of the electrical element to be controlled or the function performed), insert configuration parameters, so that the device can be suitably identified and managed, according to the desired operating specifications. This procedure is repeated for all the inter-communicating devices with a simplified function that allows the recurring system configuration parameters to be replicated on all the devices subsequent to the first. The user can define secure access to their own domestic control system and distribute accesses to authorized members.

The system allows events to be detected and corresponding actions to be configured. E.g.: if there is no voltage, it sends a message.

The Application can interact with cloud services able to manage the control of its own system in an optimal way. By way of non-exhaustive example, services will be provided for optimizing the climate control of the relevant environment according to presence, habits but also the weather forecast. Information will be provided on the solar cycle so as to determine the automatic switch-on of night lights, the presence of strong wind in order to automatically retract sun blinds...

The application allows the aesthetic configuration of LCD control interfaces, based on graphical models.

The application updates can be downloaded from the internet, hence guaranteeing the evolution of the system and the customization thereof. In particular, the Application will evolve developing appropriate interfaces towards sub-systems such as anti-intrusion, climate control, household appliances, etc..., with the aim of guaranteeing complementarity and coordination.

With preferable reference to the Functional module C), the functional specialization of the home automation device of the invention is determined and increased by the following components that can be inserted individually and possibly in combination with each other, in addition to the components described above.
a) Microphone and Loudspeaker
b) LCD Interface + Touch Screen
c) Temperature sensor
d) Brightness sensor
e) Infrared sensor + set of lenses
f) Microwave sensor + infrared sensor + set of lenses
g) Flood sensor
h) Smoke sensor
i) Infrared transmitter
j) Transponder
k) GSM/UMTS/LTE module
l) Camcorder
m) Aesthetic cap
n) Bluetooth/Beacon
o) RJ45 connector

The functional specializations listed above determine the operational qualification of the device, but however represent a non-exhaustive description. In fact, the structural characterization of the device and its programmatic flexibility allow a further extension of its operational abilities, through the use of other functional modules that can be subsequently introduced.

One or more of these components can be inserted either inside the device, or connected to the device from the outside in a known way.

The functional components and/or its accessories can extend the dimension (depth) of the device outside the electrical box.

The implementation of the functional specializations listed above is described in detail below.

### a) Microphone and Loudspeaker.

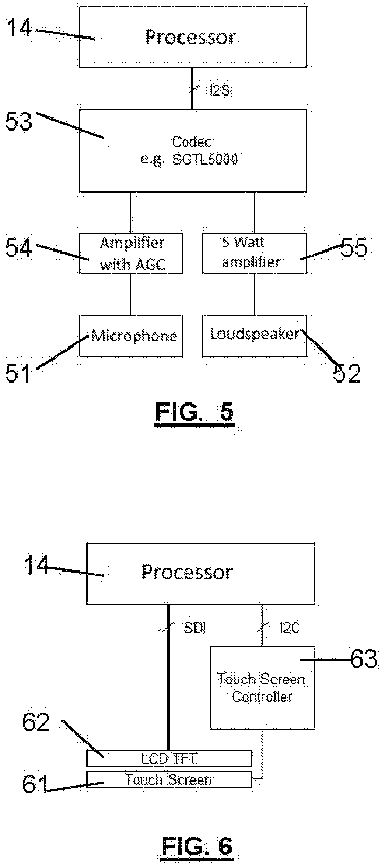

With reference to Figure 5, in this embodiment it is proposed to jointly use two additional functional components, Microphone 51 and Loudspeaker 52, which can be connected to an audio codec 53 that digitalizes the information (e.g. the Freescale SGTL5000). It is possible to interpose a pre-amplifier with the AGC (Auto Gain Controller) system 54 for the microphone and a class D amplifier 55, of a few Watts, for the loudspeaker. The audio codec 53 is connected to the Processor module 14. The connection can be realized through a classic audio digital interface (e.g. I2S - Integrated Interchip Sound).

### b) LCD Interface + Touch Screen.

With reference to Figure 6, a possible embodiment of the LCD + Touch Screen interface 61 is a 1.44" LCD TFT 62 that integrates a graphics processing unit and is presented with a serial communication output, such as UART, SPI, SDI, etc. In this way the display can be directly connected electronically with the Processor module 14 which drives the operation thereof. A touch screen (e.g. of the capacitive type) can also be superposed on the display, of the same size, which can be connected to the processor module through a touch screen controller 62 that has a digital communication interface (e.g. I2C).

### c) Temperature sensor.

This functionality can be realized using a simple integrated temperature sensor (e.g.: Texas Instruments LM35) which, through a relevant circuit, is connected to an analog input of the Processor module 14. Through an ADC (Analog to Digital Converter), the processor module digitalizes the signal and thus obtains the temperature, by means of a dedicated algorithm.

### d) Brightness sensor.

This functionality can be realized using a simple photoresistor which, through a relevant circuit, is connected to an analog input of the Processor module 14. Through an ADC (Analog to Digital Converter), the processor module digitalizes the signal and thus obtains the brightness, by means of a dedicated algorithm.

### e) Infrared sensor + set of lenses.

This functionality can be realized using a simple PIR (Passive InfraRed) sensor which, through a relevant circuit, is connected to an analog input of the Processor module 14. Through an ADC (Analog to Digital Converter), the processor module digitalizes the signal and thus obtains the sensitive data, by means of a dedicated algorithm.

It is possible to insert a lens which makes it possible to modify the angle, the depth and the direction of the visual field of the sensor itself.

In more specific contexts, it may be necessary to use an active infrared sensor. In this case the electronic circuit differs from the passive one only due to the power supply, given that the active sensor works by generating an infrared signal and detecting the reflected waves.

### f) Microwave sensor.

As for the active infrared sensor, this type of sensor needs a transmission circuit and a reception circuit. The two circuits each finish with their own antenna, a transmission one and a reception one. Each circuit is driven by the Processor module 14, which must manage the synchronization between the transmission and the reception, obtaining the sensitive data, through dedicated algorithms.

### g) Flood sensor.

This functionality can be realized using a simple circuit that measures the resistivity at the ends of two rods. Through a relevant circuit the output of the measurement circuit is connected to an analog input of the Processor module. Through an ADC (Analog to Digital Converter) and a dedicated algorithm the processor module digitalizes the signal and obtains the resistance value corresponding to the presence of water or of conductive substances/materials.

### h) Smoke sensor.

This functionality can be realized using a simple integrated smoke sensor for detecting carbon monoxide (e.g.: Olimex MQ-7) which, through a relevant circuit, is connected to a digital input of the Processor module.

### i) Infrared transmitter.

This functionality can be realized using a simple IrDA type serial interface connected to the "Processor" module. This functionality allows signals to be generated for controlling other devices, such as climate control or multimedia systems.

### J) Transponder RFID reader, electronic key.

This functionality, which can be realized through a small antenna positioned on the front wall of the device and whose incoming signal, through a relevant processing circuit, is received by the Processor, allows encoded electronic keys to be read, for enabling controlled entry, such as an access door.

### k) GSM/UMTS/LTE module.

This functionality allows the access of the device to the mobile data network. Any module on the market can be used appropriately connected to the Processor module 14.

This module is equipped with an antenna that can be integrated into the device, or an external antenna can be used.

### l) Camcorder.

This functionality can be realized using a camcorder with a digital output connected to the Processor module 14, such as USB (Universal Serial Bus) or CSI (Camera Serial Interface). m) Cosmetic cap.

This element does not represent any operating extension, but simply has an aesthetic function. In fact, in the event that the home automation device is used as an actuator of a remote function, the Element can be "closed" with a closing cap.

### n) Bluetooth/Beacon.

This functionality can be realized by integrating the digital part in the SoC and realizing an integrated antenna on a printed circuit.

It allows Bluetooth technology to be exploited for communicating with other devices for configuration or service activities. Through Bluetooth technology and the use of Beacons, it is possible to activate specific functions on smartphones, smart watches or tablets, in proximity to the device itself, such as automatically displaying in the management application the closest devices that could be controlled, facilitating the usability thereof.

### o) RJ45 connector.

This functionality can be realized by connecting the communication system (Wireless and/or Wired) present in the logical module to a physical female connector (standard RJ45). It allows an Element to be defined as a network connector for connecting to the system any other external devices not equipped with a Wireless communication system.

Possible variants to the non-limiting example described are possible but without departing from the scope of protection of the present invention, comprising all the equivalent realizations for a person skilled in the art.

The elements and characteristics illustrated in the different preferred embodiments may be combined with each other without this departing from the scope of protection of the present invention.

The advantages deriving from the application of the present invention are clear.

The device allows the local, remote and centralized control of the domestic electrical elements (domotics), with minimal or no impact on the existing electrical system. The only wiring requirement of the installation is the presence of Phase and Neutral electrical cables in the electrical box where the device is installed.

The device condenses sophisticated, hardware and software technology, which communicates in Wireless and/or Wired mode with the Application that controls it, in the dimension of a single electrical module, commonly known as "electrical element".

With the device it is possible to introduce domotics to a normal home or office, also partially intervening on some classes of objects such as lighting appliances or these plus heating/conditioning, controlled sockets, presence detection. The user can also replace only the electrical modules relative to the element that he/she intends to manage, such as a switch for each lighting point. To understand the benefit of the technical solution proposed it is important to consider, by way of example, that the device can guarantee the management of a lighting appliance, in switched mode, by replacing just one of the switches that control it. Furthermore, through its modular composition it is equipped with shape compatibility to replace the existing modules ("electrical elements") without implying the expensive replacement of frames and plates.

The device makes it possible to manage the switching on of objects connected to a socket, by controlling the socket itself.

The final user can perform the work independently by wiring the device in the same way as the electromechanical element that it replaces. At the end of the physical installation it will be possible to configure and verify the operation through a simple configuration process, by means of a dedicated Application.

Should it be necessary to perform small modifications on the system with the intervention of a professional electrician, the installation and configuration of the device will be a simple, quick and cheap activity.

The device is built so as to separate the electromechanical part, which is wired inside the electrical box (Frame), from the active and intelligent part which is inserted frontally through a "slide" system (Element), through a simple insertion operation, further simplifying the installation, maintenance and implementation activities.

The home automation device of the invention has a modular composition physical structure, with the capacity to be specialized functionally and to cover practically all the typical needs of home automation, without having to modify the wiring of the electrical system.

This home automation solution can be introduced gradually, simply by replacing the existing electromechanical components, commonly known as electrical elements, with the corresponding devices of the present invention. Thanks to the shape compatibility of the component called the Frame, it is possible to replace some existing electromechanical devices, avoiding having to also replace the corresponding frames and plates. Furthermore, the replacement or partial introduction of some devices does not imply the need to replace the remaining ones or to modify their wiring.

The home automation device of the invention has an electronic and programmable composition as an IOT class smart actuator, able to communicate with the other devices installed in an environment and to perform complex and coordinated functions in a "confederation" of intercommunicating smart objects. Such objects can be controlled locally, through relevant interfaces present on the "control" class functional specialization module, but can also be controlled remotely through specific applications for PCs, smart devices and clouds.

"Reader" class functional specialization objects such as sensors and camcorders, obtain information on significant events in the setting in which they are placed. "Communication" class functional specialization objects allow interaction with other sub-systems, through specific physical and logical gateways. The set of significant information and events, along with the interactions with other sub-systems and inputs provided by the local or remote control interfaces, constitutes a complex and scalable home automation system.

From the above description, a person skilled in the art is able to realize the object according to the invention without having to introduce further construction details.

## Claims

1. Modular multifunctional home automation device adapted to be inserted as an element in an electrical box, said element having an enclosure having the size of a single "Electric element" and being constructed to have outer shapes compatible with frames and plates of the existing electrical boxes based on the different national or international standards, wherein said element comprises:
- an actuator module (A) comprising:
- a transformer/power supply (11) for generating a low voltage (Vcc) to supply the other components,
- a voltage modulator (12) comprising at least one electronic regulator connected to at least two outputs (U1, U2) for wiring to an existing electrical grid or net of a room; said electronic regulator piloting said at least two outputs (U1, U2);
- a logical module (B) connected with said actuator module (A) and comprising:
- an electronic processor (14) for the management and control of the functions of said voltage modulator (12);
- a non-volatile memory (15) to save information that allows the proper functioning of the home automation device, even in case of power failure,
- a Wireless and/or Wired communication system (13) for bidirectional communication with outside devices,
- a functional module (C), connected to said logical module (B), and placed in said enclosure so as to have at least one face facing the outside of said electrical box, said at least one face comprising:
- a touchscreen display (62) connected to said electronic processor (14); and
- a sensor configured to obtain information on significant events in said room of said building,
wherein said Wireless and/or Wired communication system (13) is configured for receiving instruction from and/or sending instruction to another modular multifunctional home automation device;
wherein said electronic processor (14) is configured for receiving instruction for driving said voltage modulator (12) from either said Wireless and/or Wired communication system (13) or said touchscreen display (62) or said sensor so as to manage the multifunctional home automation device either internally to or from the outside of said room.

2. Modular multifunctional home automation device according to claim 1, wherein said element comprises the following additional electrical and electronic components:
- a voltage sensor (21),
- a current meter (31),
- a tank capacitor (41) adapted to cooperate with said transformer/power supply (11) to supply current in the event of a power failure.

3. Modular multifunctional home automation device according to claim 1 or 2, wherein said element comprises two physical modules:
- a hollow frame module (71), with a shape adapted to be grafted permanently but removably as an element in an electrical box, said frame module having a front opening, provided with electrical contacts on the outer bottom (73) for wiring to the power grid or net, also provided with electrical contacts on the inner side;
- an element module (72) adapted to be removably inserted in said hollow frame module (71) through said front opening, said element module being provided with electrical contacts adapted for insertion into the electrical contacts of the frame module.

4. Modular multifunctional home automation device according to claim 1, wherein said electrical and electronic components: Wireless and/or Wired communication system (13), voltage sensor (21), current meter (31), tank capacitor (41), are included jointly or separately in said actuator module (A), and/or logical module (B), and/or functional module (C).

5. Modular multifunctional home automation device according to claim 1 or 4, wherein said actuator module (A), logical module (B), functional module (C) are connected in cascade, respectively in internal, intermediate and external position in said socket module (72), so that an outer part of the functional module (C) can partially project from the outer edge of the electrical box.

6. Modular multifunctional home automation device according to claim 1, wherein said functional characterization elements of said functional module (C) comprise one or more of the following elements:
a) Microphone and Loudspeaker
b) Temperature sensor
c) Brightness sensor
d) Infrared sensor + set of lenses
e) Microwave sensor + infrared sensor + set of lenses
f) Flood sensor
g) Smoke sensor
h) Infrared transmitter
i) Transponder
l) GSM/UMTS/LTE module
m) Camcorder
n) Cosmetic cap
o) Bluetooth/Beacon
p) RJ45 connector

7. Modular multifunctional home automation device according to claim 1, wherein said logical module (B) is adapted to include a Software application for managing communication between said home automation device and/or other intercommunicating home automation devices, and/or external devices such as SmartWatch, SmartPhone, Tablets or Computers, and/or appropriate Cloud services, by means of said Wireless and/or Wired communication system (13) and TCP/IP network protocols, said Software application being also adapted to manage the configuration, operation and the software updates of said home automation device.

8. Modular multifunctional home automation device according to claim 1, wherein a joint (78) is provided between said Logical module (B) and Functional module (C), the joint being adapted to be swivelled to cover a hemisphere, the joint being adapted to extend the dimension (depth) of the socket module (72) outside the electrical box.

9. Modular multifunctional home automation device according to any one of the previous claims, wherein said device is designed such that its components are inserted in enclosures of different shape, according to the functional specialization of the device, in such a way as to ensure the mutual shape compatibility.

## Patentansprüche

1. Modulare multifunktionale Heim-Automatisierungsvorrichtung, die dazu geeignet ist, als ein Element in einen Schaltschrank eingefügt zu werden, wobei das Element eine Einhausung aufweist, die die Größe eines einzelnen "Schaltschrankelements" aufweist, und so konstruiert ist, dass es eine äußere Form aufweist, die mit Rahmen und Platten der bestehenden Schaltschränke auf Grundlage der unterschiedlichen nationalen und internationalen Normen kompatibel sind,
wobei das Element umfasst:
- ein Stellgliedmodul (A) umfassend:
- einen Transformator / eine Stromversorgung (11) zum Erzeugen einer Niederspannung (Vcc) zur Versorgung der anderen Komponenten,
- einen Spannungsmodulator (12) umfassend zumindest einen elektronischen Regler, der mit zumindest zwei Ausgängen (U1, U2) zur Verdrahtung mit einem bestehenden elektrischen Netz oder Kreis eines Raums verbunden ist; wobei der elektronische Regler die zumindest zwei Ausgänge (U1, U2) pilotsteuert;
- ein Logikmodul (B), das mit dem Stellgliedmodul (A) verbunden ist und umfasst:
- einen elektronischen Prozessor (14) für die Verwaltung und Steuerung der Funktionen des Spannungsmodulators (12);
- einen nicht flüchtigen Speicher (15) zum Sichern von Informationen, welche die korrekte Funktion der Heim-Automatisierungsvorrichtung auch im Fall eines Stromausfalls ermöglichen,
- ein drahtloses oder drahtgebundenes Kommunikationssystem (13) für die bidirektionale Kommunikation mit externen Einrichtungen,
- ein funktionelles Modul (C), das mit dem Logikmodul (B) verbunden und in der Einhausung platziert ist, um zumindest eine zur Außenseite des Schaltschranks weisende Seite aufzuweisen, wobei die zumindest eine Seite umfasst:
- eine Berührungsbildschirm-Anzeige (62), die mit dem elektronischen Prozessor (14) verbunden ist; und
- einen Sensor, der dazu ausgestaltet ist, Informationen über signifikante Ereignisse in dem Raum des Gebäudes zu erhalten,
wobei das drahtlose und/oder drahtgebundene Kommunikationssystem (13) dazu ausgestaltet ist, Anweisungen von einer weiteren modularen multifunktionalen Heim-Automatisierungsvorrichtung zu empfangen und/oder an diese zu senden;
wobei der elektronische Prozessor (14) dazu ausgestaltet ist, Anweisungen zum Ansteuern des Spannungsmodulators (12) entweder von dem drahtlosen und/oder drahtgebundenen Kommunikationssystem (13) oder der Berührungsbildschirm-Anzeige (62) oder dem Sensor zu empfangen, um die multifunktionale Heim-Automatisierungsvorrichtung entweder von innerhalb oder von außerhalb des Raums zu verwalten.

2. Modulare multifunktionale Heim-Automatisierungsvorrichtung nach Anspruch 1, wobei das Element die folgenden zusätzlichen elektrischen und elektronischen Komponenten umfasst:
- einen Spannungssensor (21),
- einen Strommesser (31),
- einen Topfkondensator (41), der dazu geeignet ist, mit dem Transformator / der Stromversorgung (11) zusammenzuwirken, um im Fall eines Stromausfalls Strom bereitzustellen.

3. Modulare multifunktionale Heim-Automatisierungsvorrichtung nach Anspruch 1 oder 2, wobei das Element zwei physische Module umfasst:
- ein hohles Rahmenmodul (71), mit einer Gestalt, die dazu geeignet ist, permanent, aber entfernbar als ein Element in einen Schaltschrank eingefügt zu werden, wobei das Rahmenmodul eine vordere Öffnung aufweist, die mit elektrischen Kontakten an dem äußeren Boden (73) zur Verkabelung mit dem Leistungsnetz oder -kreis versehen ist, und auch mit elektrischen Kontakten auf der Innenseite versehen ist;
- ein Elementmodul (72), das dazu geeignet ist, entfernbar in das hohle Rahmenmodul (71) durch die vordere Öffnung eingefügt zu werden, wobei das Elementmodul mit elektrischen Kontakten versehen ist, die zum Einsetzen in die elektrischen Kontakte des Rahmenmoduls geeignet sind.

4. Modulare multifunktionale Heim-Automatisierungsvorrichtung nach Anspruch 1, wobei die elektrischen und elektronischen Komponenten: drahtloses und/oder drahtgebundenes Kommunikationssystem (13), Spannungssensor (21), Strommesser (31), Topfkondensator (41) gemeinsam oder separat in dem Stellgliedmodul (A), und/oder dem Logikmodul (B), und/oder dem funktionellen Modul (C) beinhaltet sind.

5. Modulare multifunktionale Heim-Automatisierungsvorrichtung nach Anspruch 1 oder 4, wobei das Stellgliedmodul (A), das Logikmodul (B), das funktionelle Modul (C) in Kaskade geschaltet sind, jeweils in einer inneren, mittleren und äußeren Position in dem Sockelmodul (72), so dass ein äußerer Teil des funktionellen Moduls (C) zum Teil über den Außenrand des Schaltschranks hinausragen kann.

6. Modulare multifunktionale Heim-Automatisierungsvorrichtung nach Anspruch 1, wobei die funktionell charakteristischen Elemente des funktionellen Moduls (C) eines oder mehrere der folgenden Elemente umfassen:
a) Mikrofon und Lautsprecher
b) Temperatursensor
c) Helligkeitssensor
d) Infrarotsensor + Linsensatz
e) Mikrowellensensor + Infrarotsensor + Linsensatz
f) Überflutungssensor
g) Rauchdetektor
h) Infrarotsender
i) Transponder
l) GSM/UMTS/LTE-Modul
m) Camcorder
n) Kosmetische Kappe
o) Bluetooth/Beacon
p) RJ45-Verbinder.

7. Modulare multifunktionale Heim-Automatisierungsvorrichtung nach Anspruch 1, wobei das Logikmodul G3) dazu geeignet ist, eine Software-Anwendung zur Verwaltung der Kommunikation zwischen der Heim-Automatisierungsvorrichtung und/oder anderen damit kommunizierenden Heim-Automatisierungsvorrichtungen und/oder externen Einrichtungen wie etwa SmartWatch, SmartPhone, Tablets oder Computern, und/oder geeigneten Cloud-Diensten zu beinhalten, mittels des drahtlosen und/oder drahtgebundenen Kommunikationssystems (13) und TCP/TP-Netzwerk-Protokollen, wobei die Anwendung auch dazu geeignet ist, die Konfiguration, den Betrieb und die Software-Aktualisierungen der Heim-Automatisierungsvorrichtung zu verwalten.

8. Modulare multifunktionale Heim-Automatisierungsvorrichtung nach Anspruch 1, wobei ein Gelenk (78) zwischen dem Logikmodul (B) und dem funktionellen Modul (C) vorgesehen ist, wobei das Gelenk dazu geeignet ist, verschwenkt zu werden, um eine Hemisphäre abzudecken, wobei das Gelenk dazu geeignet ist, sich über die Dimension (Tiefe) des Sockelmoduls (72) außerhalb des Schaltschranks zu erstrecken.

9. Modulare multifunktionale Heim-Automatisierungsvorrichtung nach einem der vorhergehenden Ansprüche, wobei die Vorrichtung so konstruiert ist, dass ihre Komponenten in Einhausungen unterschiedlicher Gestalt je nach der funktionellen Spezialisierung der Vorrichtung eingesetzt sind, so dass ihre gegenseitige Formkompatibilität sichergestellt ist.

## Revendications

1. Dispositif domotique multifonctionnel modulaire conçu pour être inséré en tant qu'élément dans un coffret électrique, ledit élément présentant un boîtier ayant la taille d'un « élément électrique » unique et étant construit de manière à avoir des formes extérieures compatibles avec les cadres et les plaques des coffrets électriques existants sur la base des différentes normes nationales ou internationales, dans lequel ledit élément comprend :
- un module actionneur (A) comprenant :
- un transformateur électrique/une alimentation électrique (11) pour générer une basse tension (Vcc) afin d'alimenter les autres composants,
- un modulateur de tension (12) comprenant au moins un régulateur électronique connecté à au moins deux sorties (U1, U2) afin d'assurer le branchement à un réseau électrique existant ou à un secteur d'alimentation électrique d'une pièce ; ledit régulateur électronique pilotant lesdites au moins deux sorties (U1, U2) ;
- un module logique (B) connecté audit module actionneur (A) et comprenant :
- un processeur électronique (14) pour la gestion et le contrôle des fonctions dudit modulateur de tension (12) ;
- une mémoire non volatile (15) pour enregistrer les informations qui permettent le bon fonctionnement du dispositif domotique, même en cas de panne de courant,
- un système de communication sans fil et/ou câblé (13) pour une communication bidirectionnelle avec des dispositifs extérieurs,
- un module fonctionnel (C), connecté audit module logique (B) et placé dans ledit boîtier de manière à avoir au moins une face orientée vers l'extérieur dudit coffret électrique, ladite au moins une face comprenant :
- un écran tactile (62) connecté audit processeur électronique (14) ; et
- un capteur configuré pour obtenir des informations sur des événements significatifs dans ladite pièce dudit bâtiment,
dans lequel ledit système de communication sans fil et/ou câblé (13) est configuré pour recevoir une instruction en provenance d'un autre dispositif domotique multifonctionnel modulaire et/ou envoyer une instruction à ce dernier ;
dans lequel ledit processeur électronique (14) est configuré pour recevoir une instruction afin de commander ledit modulateur de tension (12) soit en provenance dudit système de communication sans fil et/ou câblé (13), soit en provenance dudit écran tactile (62) soit en provenance dudit capteur de manière à gérer le dispositif domotique multifonctionnel soit à l'intérieur de ladite pièce soit à partir de l'extérieur de cette dernière.

2. Dispositif domotique multifonctionnel modulaire selon la revendication 1, dans lequel ledit élément comprend les composants électriques ou électroniques supplémentaires suivants :
- un capteur de tension (21),
- un ampèremètre (31),
- un condensateur de réservoir (41) conçu pour coopérer avec ledit transformateur électrique/ladite alimentation électrique (11) afin de fournir du courant en cas de panne de courant.

3. Dispositif domotique multifonctionnel modulaire selon la revendication 1 ou 2, dans lequel ledit élément comprend deux modules physiques :
- un module de cadre (71) creux, avec une forme conçue pour être greffée en permanence mais de façon amovible en tant qu'élément dans un coffret électrique, ledit module de cadre présentant une ouverture avant, dotée de contacts électriques sur le fond extérieur (73) afin d'assurer le branchement à un réseau électrique ou au secteur d'alimentation électrique, également dotée de contacts électriques sur le côté intérieur ;
- un module d'élément (72) conçu pour être inséré de façon amovible dans ledit module de cadre (71) creux à travers ladite ouverture avant, ledit module d'élément étant doté de contacts électriques conçus pour être insérés dans les contacts électriques du module de cadre.

4. Dispositif domotique multifonctionnel modulaire selon la revendication 1, dans lequel lesdits composants électriques et électroniques : le système de communication sans fil et/ou câblé (13), le capteur de tension (21), l'ampèremètre (31), le condensateur de réservoir (41), sont inclus conjointement ou séparément dans ledit module actionneur (A), et/ou ledit module logique (B), et/ou ledit module fonctionnel (C).

5. Dispositif domotique multifonctionnel modulaire selon la revendication 1 ou 4, dans lequel ledit module actionneur (A), ledit module logique (B), ledit module fonctionnel (C) sont connectés en cascade, respectivement en position interne, intermédiaire et externe dans ledit module de douille (72), de telle sorte qu'une partie extérieure du module fonctionnel (C) peut partiellement faire saillie depuis le bord extérieur du coffret électrique.

6. Dispositif domotique multifonctionnel modulaire selon la revendication 1, dans lequel lesdits éléments de caractérisation fonctionnelle dudit module fonctionnel (C) comprennent un ou plusieurs des éléments suivants :
a) microphone et haut-parleur
b) capteur de température
c) capteur de luminosité
d) capteur infrarouge + ensemble de lentilles
e) sondeur hyperfréquence + capteur infrarouge + ensemble de lentilles
f) détecteur d'inondation
g) détecteur de fumée
h) émetteur infrarouge
i) transpondeur
l) module GSM/UMTS/LTE
m) camescope
n) bouchon cosmétique
o) Bluetooth/balise
p) connecteur RJ45

7. Dispositif domotique multifonctionnel modulaire selon la revendication 1, dans lequel ledit module logique (B) est conçu pour inclure une application logicielle afin de gérer la communication entre ledit dispositif domotique et/ou d'autres dispositifs domotiques à intercommunication, et/ou des dispositifs extérieurs tels que des montres connectées, des téléphones intelligents, des tablettes ou des ordinateurs, et/ou des services en nuage appropriés, au moyen dudit système de communication sans fil et/ou câblé (13) et de protocoles de réseau TCP/IP, ladite application logicielle étant également conçue pour gérer la configuration, le fonctionnement et les mises à jour logicielles dudit dispositif domotique.

8. Dispositif domotique multifonctionnel modulaire selon la revendication 1, dans lequel un joint (78) est prévu entre ledit module logique (B) et ledit module fonctionnel (C), le joint étant conçu pour être pivoté afin de recouvrir un hémisphère, le joint étant conçu pour étendre la dimension (profondeur) du module de douille (72) en dehors du coffret électrique.

9. Dispositif domotique multifonctionnel modulaire selon l'une quelconque des revendications précédentes, dans lequel ledit dispositif est conçu de telle sorte que ses composants sont insérés dans des boîtiers de différente forme, en fonction de la spécialisation fonctionnelle du dispositif, de telle sorte à garantir la compatibilité de forme mutuelle.
